Europäisches Patentamt

European Patent Office

Office européen des brevets

(11) Publication number: **0 155 521 B1**

## EUROPEAN PATENT SPECIFICATION

(45) Date of publication of patent specification: **11.11.92**   (51) Int. Cl.5: **G11C 5/02**, G11C 11/401

(21) Application number: **85101832.5**

(22) Date of filing: **11.12.80**

(60) Publication number of the earlier application in accordance with Art.76 EPC: **0 031 659**

(54) **A semiconductor memory device.**

(30) Priority: **13.12.79 JP 162079/79**

(43) Date of publication of application:
**25.09.85 Bulletin 85/39**

(45) Publication of the grant of the patent:
**11.11.92 Bulletin 92/46**

(84) Designated Contracting States:
**DE FR GB NL**

(56) References cited:
**DE-A- 2 746 336          DE-A- 2 919 166**
**US-A- 4 044 340          US-A- 4 099 162**
**US-A- 4 122 546          US-A- 4 160 275**

**IBM TECHNICAL DISCLOSURE BULLETIN, vol. 16, no. 7, December 1973, page 2418, New York, US; W.K. HOFFMAN: "Interleaved memory array"**

**IBM TECHNICAL DISCLOSURE BULLETIN, vol. 21, no. 3, August 1978, pages 1130-1132, New York, US; D.A. SODERMAN: "Layout structure of one device cell random-access memory"**

**PATENT ABSTRACTS OF JAPAN, vol. 4, no. 78 (P-14)[560], 6th June 1980, page 39 P 14; &**

**JP-A-55 42 344**

(73) Proprietor: **FUJITSU LIMITED**
**1015, Kamikodanaka Nakahara-ku**
**Kawasaki-shi Kanagawa 211(JP)**

(72) Inventor: **Sakurai, Junji c/o FUJITSU LIMITED**
**Patent Department 1015 Kamikodanaka**
**Nakahara-ku Kawasaki-shi Kanagawa 211(JP)**

(74) Representative: **Sunderland, James Harry et al**
**HASELTINE LAKE & CO Hazlitt House 28**
**Southampton Buildings Chancery Lane**
**London WC2A 1AT(GB)**

## Description

The present invention relates to a semiconductor memory device, and is concerned for example with the disposition of peripheral circuit blocks in a semiconductor memory having a high density memory matrix, and more particularly for instance with the layout of sense amplifiers connected to bit lines of the memory.

Since memory cell size can be reduced to as little as approximately 1 $\mu$m x 1 $\mu$m, which is considered to be the limit of current manufacturing accuracy, in a high density memory, particularly in a dynamic RAM (Random Access Memory), a large scale integrated memory device with a bit line width of 1 $\mu$m and an inter-line interval of 1 $\mu$m can be produced. However, a peripheral circuit block, for example providing address decoders to be connected to word lines or providing sense amplifiers to be connected to bit lines, cannot be accommodated within that minimum size of 1 $\mu$m x 1 $\mu$m because such a peripheral circuit block includes a large number of elements.

Currently, a sense amplifier is about 30 $\mu$m in width and bit line width is several microns.

Therefore, when a memory matrix is integrated with particularly high density as explained above, it is geometrically impossible to arrange peripheral circuits, such as sense amplifiers, in a line crossing the productions of respective bit lines serving the memory cells of such a memory matrix. That is, considering a plurality of parallel bit lines extending from a memory matrix it is impossible to arrange sufficient sense amplifiers to serve all the bit lines in a row or line perpendicular to the bit lines within the space between first and last bit lines. An attempt to provide such an arrangement will bring about a result in which portions of bit lines extending from the memory matrix and connected to the sense amplifiers spread out in the form of a fan and an area between the row of sense amplifiers and the memory matrix will be taken up in a non-useful fashion due to the expansion or fanning out of the bit lines. Moreover, the lengths of the portions of the bit lines which extend to sense amplifiers differ in accordance with the positions of the cells which the bit lines serve, and particularly in the case of a dynamic RAM comprising memory cells each of which is composed of one transistor and one capacitor, the capacities of bit lines, undesirably, become different.

US-A-4 099 162 discloses an arrangement in which two output amplifiers are arranged one partly behind and beyond the other in relation to a decoder circuit for two decoder lines which are respectively connected to the amplifiers. The width of an output amplifier can thus exceed the decoder grid size. Connecting wiring to the output amplifier further from the decoder circuit passes around the side of the nearer output amplifier.

According to the present invention there is provided a semiconductor memory device having a memory matrix area in which memory cells are provided at intersections of row and column wiring lines or wiring line pairs, and a plurality of peripheral circuits connected to row or column wiring lines or line pairs, characterised in that the peripheral circuits connected to a predetermined number of adjacent ones of said wiring lines or line pairs are arranged one after another when considered in a first direction, parallel to said wiring lines or line pairs, in such a manner that the peripheral circuits of the plurality are arranged in ranks when considered in a second direction transverse to the first direction, each peripheral circuit of the plurality having a width, in the second direction, corresponding to the distance between the first and last of n adjacent ones of said lines or line pairs, n peripheral circuits being arranged one after another, when considered in the first direction, on one side of the memory matrix area and connected directly to respective wiring lines or line pairs extending from the matrix memory area, with a first line or line pair being connected to a first of the n peripheral circuits, nearest the memory matrix area, a second line or line pair being connected to a second of the n peripheral circuits, next nearest the memory matrix area, the second line or line pair passing over the first of the n peripheral circuits, and so on.

An embodiment of the present invention can provide a semiconductor memory system in which high integration density is realised by facilitating the connections between X and Y direction wirings of a highly integrated memory matrix and peripheral circuits of peripheral circuit blocks.

An embodiment of the present invention can provide a semiconductor memory system in which the problem relating to layout which results from a large difference between the density of wirings in X and Y directions of a highly integrated memory matrix and the density of peripheral circuits in peripheral circuit blocks connected to the respective wirings is solved, and in which high integration density is provided through effective use of area.

An embodiment of the present invention can provide a semiconductor memory system in which high integration density is realised by facilitating connections between bit lines of a highly integrated memory matrix and sense amplifiers which are formed with a density different from that of the bit lines.

An embodiment of the present invention can provide a semiconductor memory system in which area is used effectively as a result of facilitation of connections between word lines and/or bit lines of a highly integrated memory matrix and decoder circuits for selecting between such lines

An embodiment of the present invention can provide a highly integrated dynamic random access memory in which the difficulty in making connections between bit lines of a memory matrix in which memory cells each comprise one transistor and one capacitor are arranged in the form of a matrix with high density, and sense amplifiers connected to the bit lines, which difficulty results from a large difference in size between bit lines and sense amplifiers is overcome, and ineffective use of the area for connections is eliminated.

An embodiment of the present invention can be provided in which memory matrix area having a large number of wirings or wiring pairs crossing in row and column directions and having memory cells arranged at intersections, has the following characteristics: a plurality of peripheral circuit blocks which are to be connected to a predetermined number of adjacent wirings or wiring pairs are sequentially arranged one block after another in the same direction as the wirings or wiring pairs to which they are to be connected in such a manner that at least some of the peripheral circuit blocks are arranged in files or ranks and wirings or wiring pairs extended from the memory matrix region are connected to the peripheral circuit blocks.

Reference is made, by way of example, to the accompanying drawings, in which:-

Figure 1 is a schematic block diagram illustrating the general structure of a conventional semiconductor memory system;

Figure 2 is a schematic block diagram illustrating the general structure of a semiconductor memory system embodying the present invention;

Figure 3 is a schematic circuit diagram of a part of the structure of a semiconductor memory system embodying the present invention; and

Figure 4 is a schematic block diagram illustrating the general structure of another semiconductor memory system embodying the present invention.

Recent semiconductor memory systems are more advanced in the achievement of high integration density for memory cell matrixes because memory cells provided at the intersections of word lines which extend in a row direction, and bit lines which extend in a column direction have been reduced in size by a variety of methods.

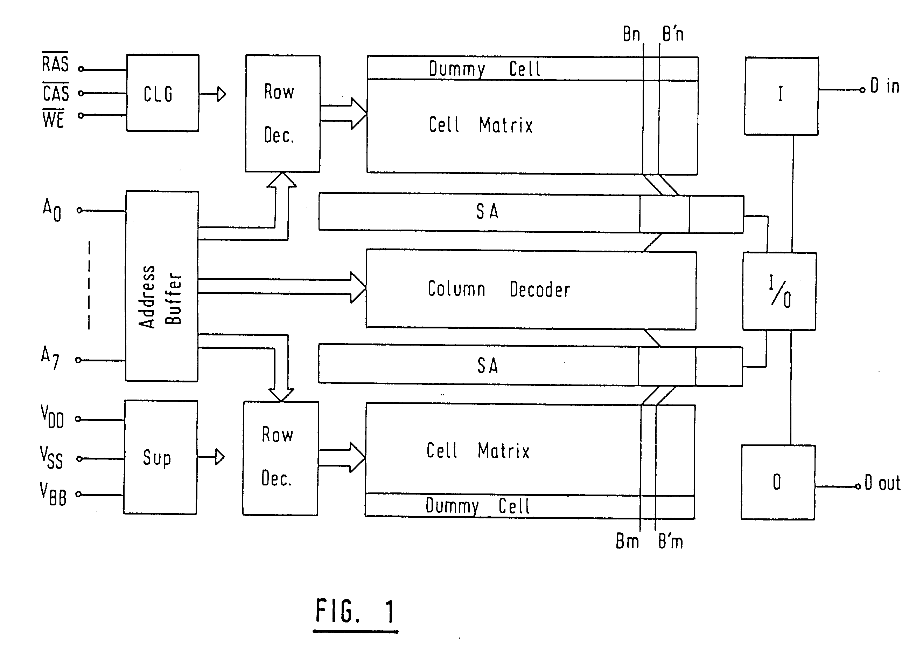

Figure 1 is a block diagram illustrating a conventional semiconductor memory system; in particular Figure 1 outlines the overall structure of a dynamic RAM comprising memory cells each of which is composed of one transistor and one capacitor. SUP is a power supply circuit which receives a variety of power source voltages $V_{DD}$, $V_{SS}$,

$V_{BB}$ from circuits external of the RAM and supplies them to the circuits internal of the RAM. CLG is the internal clock generator which receives a row address signal $\overline{RAS}$, a column select signal $\overline{CAS}$ and a write enable signal $\overline{WE}$ from external circuits and supplies predetermined clock signals to internal circuits. At the periphery of a memory cell matrix area, sense amplifiers SA and column decoders, connected to bit line pairs Bn, Bn' and Bm, Bm' etc., and row decoders connected to word lines, which word lines extend in a direction perpendicular to that of the bit line pairs, are arranged. For a memory cell selected by a column decoder and a row decoder on the basis of a signal sent from an address buffer, to which address signals $A_0$, $A_1$, ... $A_7$ are supplied, a sense amplifier senses the content of the cell by comparing a bit line Bn connected to the cell and another bit line Bn' connected to a dummy cell. Thereby data is read as output information $D_{out}$ from an output buffer 0 via an input output circuit I/O. Namely, sense amplifiers are provided in correspondence to respective bit line pairs.

$D_{in}$ represents input information which can be input to a memory cell via input buffer I and input-output circuit I/O.

In order to increase memory capacity, the memory cell matrix is improved to offer higher integration density by further reducing memory cell size. The dimensions of the bit line pairs and the sense amplifiers are not equal, and as indicated in Figure 1, sense amplifiers arranged in a line cannot be accommodated within the lateral extent of the memory cell matrix area as seen in the Figure. Therefore, the portions of the bit lines which extend for connection with the sense amplifiers spread out in the form of a fan, resulting in inefficient use of area. This contradicts the purpose of realisation of high integration density.

One way to avoid this problem is to provide multiplexer switching circuits and to use the same sense amplifier in common for the plurality of bit line pairs, as described in IEEE Journal of Solid State Circuits, Vol. SC-15, No. 2 April 1980, page 184-189.

However, it is a defect that the extra circuits, such as multiplexer switching circuits and timing clock signals for switching, are needed and a refresh time for memory cells is longer.

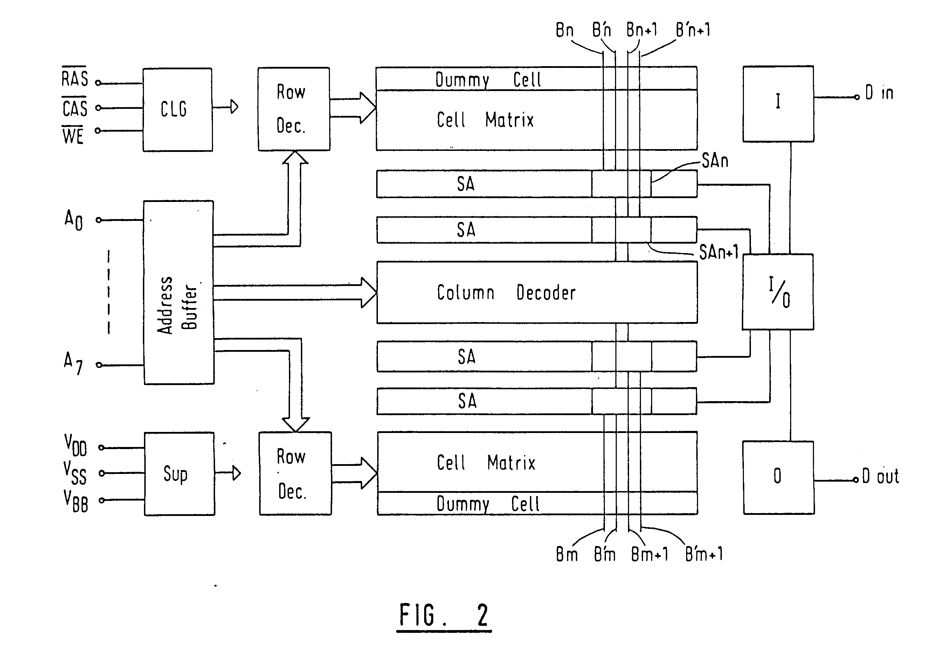

Figure 2 is a block diagram indicating the overall structure of a semiconductor memory system embodying the present invention. Parts similar to those in the memory of Figure 1 are given the same reference symbols. In a conventional memory system, sense amplifiers connected to respective bit line pairs are arranged in a line adjacent to the memory matrix area. In the embodiment of Figure 2, however, the sense amplifiers are arranged in two or more lines or files adjacent to a memory matrix area, thereby avoiding the need for extended bit line portions which spread out into the form of a fan. Namely, in the present embodiment, sense amplifiers SAn, SAn + 1 connected to adjacent bit line pairs Bn, Bn' and Bn + 1, Bn + 1' (or Bm, Bm' and Bm + 1, Bm + 1') are arranged in respective files the direction of which crosses the direction of the bit lines. Thereby, the sense amplifiers SAn, SAn + 1 can be arranged so as to lie within in the same width as the width of the two bit line pairs (i.e. the lateral extent of the two sense amplifiers, as seen in Figure 2, is substantially equal to the lateral spacing taken up by the two bit line pairs), making it possible to provide a memory matrix layout with high integration density and facilitating arrangement of the sense amplifiers even if the bit line width is reduced. Moreover, if integration density of the memory matrix is further increased, connections between sense amplifiers and bit line pairs can still be effected easily by arranging the sense amplifiers in three files or more. Thus, as seen along the direction of bit line pairs, two or more sense amplifiers overlap or are in register behind one another.

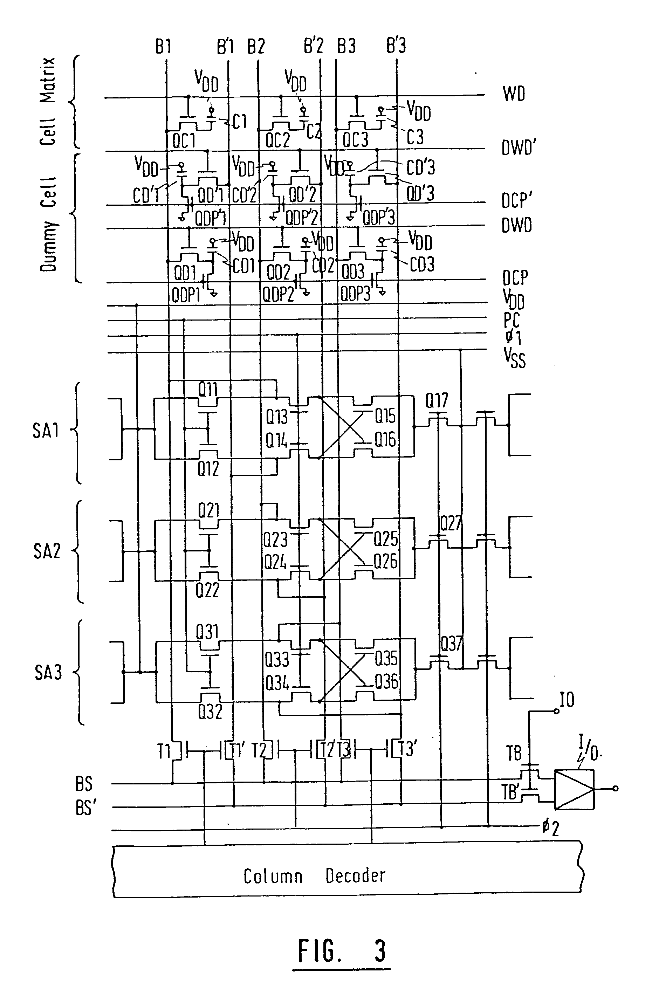

Figure 3 shows an enlarged schematic diagram of a part of Figure 2. $B_1$, $B_1'$; $B_2$, $B_2'$ and $B_3$, $B_3'$ are bit line pairs, and memory cells consisting of respective transistors $QC_1$, $QC_2$ and $QC_3$, and respective capacitors $C_1$, $C_2$ and $C_3$ are provided at the intersections between the bit line pairs and word lines WD. In addition, at intersections between the bit line pairs and dummy word lines DWD, DWD', dummy cells consisting respectively of transistors $QD_1$, $QD_1'$; $QD_2$, $QD_2'$; $QD_3$, $QD_3'$; and capacitors $CD_1$, $CD_1'$; $CD_2$, $CD_2'$; $CD_3$, $CD_3'$; and discharging transistors $QDP_1$, $QDP_1'$; $QDP_2$, $QDP_2'$; $QDP_3$, $QDP_3'$ are provided. DCP, DCP' are signal lines for discharging the dummy cells. Sense amplifiiers SA1, SA2, SA3 connected to respective bit line pairs are arranged in three files which files extend in a direction which crosses the direction of the bit line pairs. Namely, the bit line pairs $B_1$, $B_1'$; $B_2$, $B_2'$; $B_3$, $B_3'$ are directly connected in the form of straight lines, in the direction of the bit lines going away from the memory cell matrix, and three sense amplifiers SA1, SA2 and SA3 are arranged in the direction in which the bit line pairs extend. The width of a sense amplifier in the word line direction (perpendicular to the bit line direction) is almost equal to that of three bit line pairs. In other words, in the present embodiment, a value of n is obtained such that n pairs of bit lines are together approximately equal in width to the width of the one sense amplifier, the bit line pairs are divided into blocks each consisting of n pairs, and n sense amplfiers are arranged one after another in the bit line direction for each block. In Figure 3, three pairs of bit lines are approximately equal in width to one sense amplifier so three sense amplifiers, SA1, SA2 and SA3, are provided one after another in the direction of the bit lines.

The sense amplifiers SA1, SA2 and SA3 are respectively composed of transistors $Q_{11}$, $Q_{12}$, $Q_{13}$, $Q_{14}$, $Q_{15}$, $Q_{16}$, $Q_{17}$; $Q_{21}$, $Q_{22}$, $Q_{23}$, $Q_{24}$, $Q_{25}$, $Q_{26}$, $Q_{27}$; and $Q_{31}$, $Q_{32}$, $Q_{33}$, $Q_{34}$, $Q_{35}$, $Q_{36}$, $Q_{37}$ as indicated in the Figure. $V_{DD}$ is a high level power supply line, $V_{SS}$ is a low level power supply line, PC is a pre-charge signal line, $\phi_1$ is an interrupt signal line, and $\phi_2$ is a latch signal line. Each of these lines are connected to each of the sense amplifiers. The bit line pairs are connected to bus lines BS, BS' via gate transistors $T_1$, $T_1'$; $T_2$, $T_2'$; $T_3$, $T_3'$ which are turned ON and OFF under the control of a column decoder. Moreover, the bus lines are also connected to the input-output circuit I/O via transistor pair TB, TB' which are turned ON and OFF under the control of a signal IO.

The structure of the present embodiment employs a multi-layer wiring system, and provides an advantage in that all sense amplifiers are arranged on one side of a memory cell matrix area as in the case of the conventional memory system, and particular modification of the structure or layout of other peripheral circuits and the portions of the bit lines which extend for connection to sense amplifiers is not required.

The embodiment described above is adapted to a memory system of the folded bit line type, where bit line pairs are provided in parallel (the lines of the pair run alongside one another).

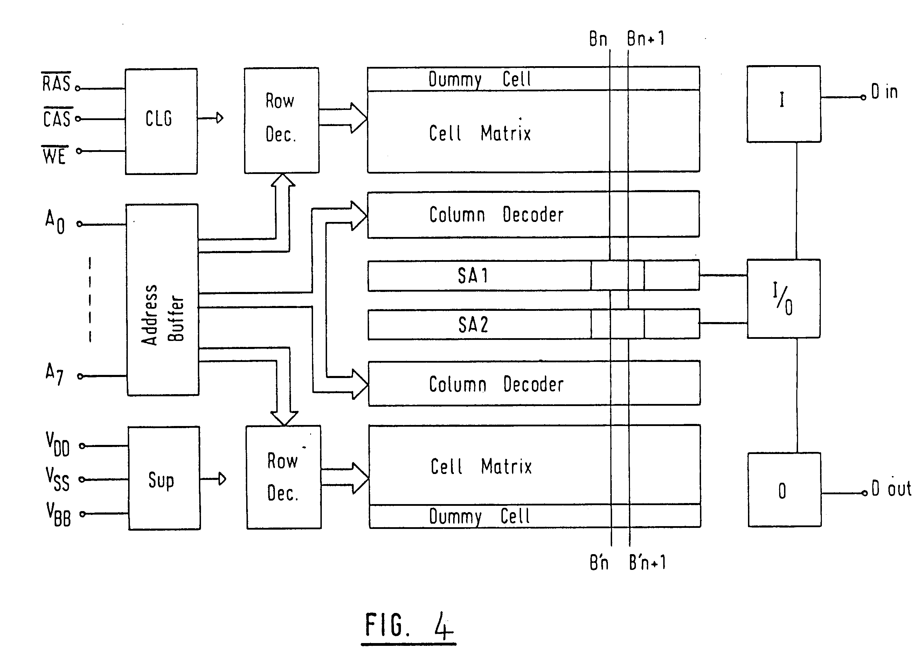

Figure 4 is a block diagram of the overall structure of another embodiment of the present invention obtained by adapting the present invention to a case in which bit line pairs Bn, Bn'; Bn + 1, Bn + 1' are spread to both sides (i.e. extend to opposite sides of a sense amplifier). In a dynamic RAM of this type, in which each memory cell consists of one transistor and one capacitor, the content of a memory cell connected to a bit line Bn is, for example, read on the basis of a comparison with the content of a dummy memory cell connected to a pairing bit line Bn'. A dynamic RAM of this type, is larger than the folded bit line type in terms of line length and the the dimensions of inter-bit lines and the degree of unbalance between the width of sense amplifiers and line width. Therefore, a notable effect can be obtained by adapting the present invention to such a type of dynamic RAM. In the present embodiment, the sense amplifiers SA1, SA2 are arranged in two ranks or files and the bit line pair. Bn, Bn' is connected to the sense amplifier SA1, while the bit line pairs Bn + 1, Bn + 1' is connected to the sense amplifier SA2.

In the above embodiments, the present invention has been explained on the basis of its application to the relationship between bit line pairs and sense amplifiers. The present invention can naturally be adapted for application to the relationship between word lines or word line pairs, or bit lines or bit line pairs and decoder circuits, such as row or column decoders and between word lines or word line pairs or bit lines or bit line pairs and any other peripheral circuits, such as word decoder circuits for selecting and driving word lines or word line pairs, connected thereto.

As explained above, the present invention has the advantage that the word lines or bit lines of a highly integrated memory matrix and peripheral circuits in a peripheral circuit block such as an address decoder, sense amplifiers etc. can be connected without complicating the overall structure and with efficient use of area.

An embodiment of the present invention relates to a semiconductor memory system having a memory matrix area wherein many word lines and bit lines cross mutually in row and column directions and memory cells are arranged at the intersections of the word lines and bit lines with high integration density. A plurality of peripheral circuit blocks which are connected to a plurality of adjacent word lines and bit lines, for example, blocks providing sense amplifiers and decoder circuits, are sequentially arranged in files against the direction of the bit lines or word lines, respectively. Thereby, connections between the word lines or bit lines and peripheral circuits can be made without complicating the structure, and with effective use of areas.

Thus, the present invention provides a semiconductor memory device providing the memory matrix area comprising plurality of wirings or wiring pairs crossed in both row and column directions and the memory cells arranged in the intersection thereof, wherein a plurality of peripheral circuit blocks connected to the adjacent plurality of wirings or wiring pairs in the predetermined number are sequentially arranged in the same direction as said wiring in such a manner that at least a part of said peripheral circuit block is arranged in files, and said wirings extended from said memory matrix area are connected to said peripheral circuit blocks.

## Claims

1. A semiconductor memory device having a memory matrix area in which memory cells are provided at intersections of row (WD) and column wiring lines ($B_i$) or wiring line pairs, and a plurality of peripheral circuits ($SA_i$) connected to said row or column wiring lines or line pairs, characterised in that the peripheral circuits ($SA_i$) connected to a predetermined number of adjacent ones of said wiring lines or line pairs ($B_i$) are arranged one after another when considered in a first direction, parallel to said wiring lines or line pairs ($B_i$), in such a manner that the peripheral circuits ($SA_i$) of the plurality are arranged in ranks when considered in a second direction, transverse to the first direction, each peripheral circuit ($SA_i$) of the plurality having a width, in the second direction, corresponding to the distance between the first and last of n adjacent ones of said wiring lines or line pairs ($B_i$), n peripheral circuits ($SA_i$) being arranged one after another, when considered in the first direction, on one side of the memory matrix area and connected directly to respective wiring lines or line pairs ($B_i$) extending from the matrix memory area, with a first line or line pair ($B_1$, $B_1'$) being connected to a first of the n peripheral circuits ($SA_1$), nearest the memory matrix area, a second line or line pair ($B_2$, $B_2'$) being connected to a second ($SA_2$) of the n peripheral circuits, next nearest the memory matrix area, the second line or line pair ($B_2$, $B_2'$) passing over the first of the n peripheral circuits ($SA_1$), and so on.

2. A device as claimed in claim 1, wherein each memory cell comprises one transistor ($QC_i$)and one capacitor ($C_i$).

3. A device as claimed in claim 1 or 2, wherein the peripheral circuits ($SA_i$) of the plurality are respective sense amplifiers and are connected to column bit lines or bit line pairs ($B_i$, $B_i'$) for detecting the potentials thereof.

4. A device as claimed in claim 1 or 2, wherein the peripheral circuits of the plurality are respective word decorders and are connected to row word lines or word line pairs for selecting and driving thereof.

5. A device as claimed in claim 1 or 2, wherein the peripheral circuits of the plurality are column decoders and are connected to column bit lines or bit line pairs for selecting columns.

6. A device as claimed in any preceding claim, being a folded bit line type device.

7. A device as claimed in any one of claims 1 to 5, having first and second such memory matrix areas, the peripheral circuits of the plurality being disposed between the first and second memory matrix areas, each connected to a line pair of which one line belongs to the first memory matrix area and the other line belongs to the second memory matrix area.

## Patentansprüche

1.  Halbleiterspeichereinrichtung mit einem Speichermatrixbereich, in dem an Kreuzungspunkten von Zeilen- (WD) und Spaltenverdrahtungsleitungen (Bi) oder -leitungspaaren Speicherzellen vorgesehen sind, und einer Vielzahl von mit den Zeilen- oder Spaltenverdrahtungsleitungen oder -leitungspaaren verbundenen peripheren Schaltungen (SAi), **dadurch gekennzeichnet,**
    daß die mit einer vorgegebenen Anzahl von benachbarten der Verdrahtungsleitungen oder -leitungspaare (Bi) verbundenen peripheren Schaltungen (SAi), in einer ersten Richtung parallel zu den Verdrahtungsleitungen oder -leitungspaaren (Bi) gesehen, so hintereinander angeordnet sind, daß die peripheren Schaltungen (SAi) der Vielzahl, in einer zweiten Richtung quer zur ersten Richtung gesehen, in Rängen oder Reihen angeordnet sind, wobei jede periphere Schaltung (SAi) der Vielzahl in der zweiten Richtung eine Breite hat, die dem Abstand zwischen der ersten und letzten Verdrahtungsleitung oder dem ersten und letzten Verdrahtungsleitungspaar von n benachbarten Verdrahtungsleitungen oder -leitungspaaren (Bi) entspricht, wobei n periphere Schaltungen (SAi), in der ersten Richtung gesehen, auf einer Seite des Speichermatrixbereichs hintereinander angeordnet und direkt mit den jeweiligen, vom Speichermatrixbereich ausgehenden Leitungen oder Leitungspaaren (Bi) verbunden sind, wobei eine erste Leitung oder ein erstes Leitungspaar (B1, B'1) mit einer ersten (SA1), dem Speichermatrixbereich nächstliegenden der n peripheren Schaltungen, eine zweite Leitung oder ein zweites Leitungspaar (B2, B'2) mit einer zweiten (SA2), dem Speichermatrixbereich am zweitnächsten liegenden der n peripheren Schaltungen verbunden ist, wobei die zweite Leitung oder das zweite Leitungspaar (B2, B'2) über der ersten (SA1) der n peripheren Schaltungen verläuft, und so weiter.

2.  Einrichtung nach Anspruch 1, bei der jede Speicherzelle einen Transistor (QCi) und einen Kondensator (Ci) aufweist.

3.  Einrichtung nach Anspruch 1 oder 2, bei der die peripheren Schaltungen (SAi) der Vielzahl jeweils Leseverstärker sind und mit Spaltenbitleitungen oder -bitleitungspaaren (Bi, Bi') zur Erkennung der darauf vorhandenen Potentiale verbunden sind.

4.  Einrichtung nach Anspruch 1 oder 2, bei der die peripheren Schaltungen der Vielzahl jeweils Wortdekodierer sind und mit Zeilenwortleitungen oder -wortleitungspaaren zu deren Auswahl und Ansteuerung verbunden sind.

5.  Einrichtung nach Anspruch 1 oder 2, bei der die peripheren Schaltungen der Vielzahl Spaltendekodierer sind und mit Spaltenbitleitungen oder -bitleitungspaaren zur Auswahl von Spalten verbunden sind.

6.  Einrichtung nach einem der vorhergehenden Ansprüche als Einrichtung mit gefalteten Bitleitungen.

7.  Einrichtung nach einem der Ansprüche 1 bis 5, mit ersten und zweiten solcher Speichermatrixbereiche, wobei die peripheren Schaltungen der Vielzahl zwischen den ersten und zweiten Speichermatrixbereichen angeordnet und jeweils mit einem Leitungspaar verbunden sind, von dem eine Leitung dem ersten Speichermatrixbereich und die andere Leitung dem zweiten Speichermatrixbereich zugeordnet ist.

## Revendications

1.  Dispositif de mémoire à semiconducteur comportant une zone de matrice de mémoire dans laquelle des cellules de mémoire sont prévues aux intersections de fils de câblage de ligne (WD) et de colonne (BL) ou de paires de fils de câblage, et une pluralité de circuits périphériques (SA$_i$) connectés auxdits fils de câblage de ligne ou de colonne ou aux paires de fils, caractérisé en ce que les circuits périphériques (SA$_i$) connectés à un nombre prédéterminé de fils voisins desdits fils de câblage ou desdites paires de fils (Bi) sont disposés les uns après les autres quand on les considère dans une première direction, parallèle auxdits fils de câblage ou paires de fils (B$_i$), de telle manière que les circuits périphériques (SA$_i$) de la pluralité sont disposés en rangs quand on les considère dans une seconde direction, transversale par rapport à la première direction, chaque circuit périphérique (SA$_i$) de la pluralité ayant une largeur, dans la seconde direction, correspondant à la distance entre le premier et le dernier de n fils voisins desdits fils de câblage ou des paires de fils (B$_i$), n circuits périphériques (SA$_i$) étant disposés les uns après les autres, quand on les considère dans la première direction, d'un côté de la zone de matrice de mémoire et connectés directement aux fils de câblages respectifs ou aux paires de fils (B$_i$) s'étendant à partir de la zone de matrice de mémoire, un premier fil ou une première paire de fils (B$_1$, B$_1$') étant connecté à

un premier des n circuits périphériques (SA$_1$), le plus près de la zone de matrice de mémoire, un deuxième fil ou une deuxième paire de fils (B$_2$,B$_2$') étant connecté à un deuxième (SA$_2$) des n circuits périphériques, le plus près ensuite de la zone de matrice de mémoire, le deuxième fil ou la deuxième paire de fils (B$_2$,B$_2$') passant par-dessus le premier des n circuits périphériques (SA$_1$), et ainsi de suite.

2. Dispositif selon la revendication 1, dans lequel chaque cellule de mémoire comprend un transistor (QC$_i$) et un condensateur (C$_i$).

3. Dispositif selon l'une quelconque des revendications 1 et 2, dans lequel les circuits périphériques (SA$_i$) de la pluralité sont des amplificateurs de détection respectifs et sont connectés aux fils de bit de colonne ou aux paires de fils de bit (B$_i$,B$_i$') pour détecter leurs potentiels.

4. Dispositif selon l'une quelconque des revendications 1 et 2, dans lequel les circuits périphériques de la pluralité sont des décodeurs de mot respectifs et sont connectés aux fils de mot de ligne ou aux paires de fils de mot pour les sélectionner et les commander.

5. Dispositif selon l'une quelconque des revendications 1 et 2, dans lequel les circuits périphériques de la pluralité sont des décodeurs de colonne et sont connectés aux fils de bit de colonne ou aux paires de fils de bit pour sélectionner des colonnes.

6. Dispositif selon l'une quelconque des revendications 1 à 5, qui est un dispositif du type à fils de bit repliés.

7. Dispositif selon l'une quelconque des revendications 1 à 5, comportant des première et seconde zones de la matrice de mémoire, les circuits périphériques de la pluralité étant disposés entre les première et deuxième zones de matrice de mémoire, chacun étant connecté à une paire de fils dont un fil appartient à la première zone de matrice de mémoire et l'autre fil appartient à la seconde zone de matrice de mémoire.

FIG. 1

D in

D out

I

I/O

O

SAn

SAn+1

B'n+1

Bn B'n Bn+1

Bm+1 B'm+1

Bm B'm Bm+1

Dummy Cell

Cell Matrix

SA

SA

Column Decoder

SA

SA

Cell Matrix

Dummy Cell

Row Dec.

Row Dec.

CLG

Address Buffer

Sup

$\overline{RAS}$
$\overline{CAS}$
$\overline{WE}$

$A_0$

$A_7$

$V_{DD}$
$V_{SS}$
$V_{BB}$

FIG. 2

9

FIG. 3

FIG. 4

EP 0 155 521 B1